# EUROPEAN PATENT SPECIFICATION

(11) **EP 4 226 273 B1**
(45) Date of publication and mention of the grant of the patent: **17.06.2026**
(21) Application number: 21893751.4
(22) Date of filing: 03.11.2021
(51) Int. Cl.: G06V 20/10, G06F 30/13, G06V 10/26, G06V 10/44, G06V 10/82, G06V 20/13, G06V 20/17, G06F 30/12

(54) **SYSTEMS AND METHODS FOR CONSTRUCTING A BUILDING BLOCK MODEL**
SYSTEME UND VERFAHREN ZUR KONSTRUKTION EINES BAUSTEINMODELLS
SYSTÈMES ET PROCÉDÉS DE CONSTRUCTION D'UN MODÈLE DE BLOC DE BÂTIMENT

(30) Priority: 18.11.2020 CN 202011295008
(43) Date of publication of application: 16.08.2023
(73) Proprietor: Zhejiang Dahua Technology Co., Ltd., Hangzhou, Zhejiang 310053 (CN)
(72) Inventor: REN, Yupeng, Hangzhou, Zhejiang 310053 (CN); LIU, Yiying, Hangzhou, Zhejiang 310053 (CN); WANG, Junyi, Hangzhou, Zhejiang 310053 (CN); LU, Wei, Hangzhou, Zhejiang 310053 (CN); YIN, Jun, Hangzhou, Zhejiang 310053 (CN)
(74) Representative: Wang, Bo
(86) International application number: PCT/CN2021/128395
(87) International publication number: WO 2022/105604

(56) References cited:
- WO-A1-2020/207512
- CN-A- 101 114 385
- CN-A- 101 290 222
- CN-A- 108 765 488
- CN-A- 111 597 496
- CN-A- 112 115 926
- US-A1- 2011 292 208
- TREKIN A N ET AL: "Deep Neural Networks for Determining the Parameters of Buildings from Single-Shot Satellite Imagery", JOURNAL OF COMPUTER AND SYSTEMS SCIENCES INTERNATIONAL, PLEIADES PUBLISHING, MOSCOW, vol. 59, no. 5, 1 September 2020 (2020-09-01), pages 755 - 767, XP037265157, ISSN: 1064-2307, [retrieved on 20201011], DOI: 10.1134/S106423072005007X
- P MEIXNER ET AL: "DESCRIBING BUILDINGS BY 3-DIMENSIONAL DETAILS FOUND IN AERIAL PHOTOGRAPHY", PROCEEDINGS OF ISPRS TC VII SYMPOSIUM - 100 YEARS ISPRS, vol. XXXVIII, 1 January 2010 (2010-01-01), pages 151 - 156, XP055223065
- TRIPODI SEBASTIEN ET AL: "Operational Pipeline for Large-Scale 3D Reconstruction of Buildings From Satellite Images", 26 September 2020 (2020-09-26), pages 445 - 448, XP055866131, ISBN: 978-1-7281-6374-1, Retrieved from the Internet <URL:https://ieeexplore.ieee.org/stampPDF/getPDF.jsp?tp=&arnumber=9324213&ref=aHR0cHM6Ly9pZWVleHBsb3JlLmllZWUub3JnL2Fic3RyYWN0L2RvY3VtZW50LzkzMjQyMTM/Y2FzYV90b2tlbj1FUmVLdUdlQUNhVUFBQUFBOnpnV0M4UkdiN2VRSDdNYndkMy1WaEg5TThUcXlzMWd6akVleVpqVUxOOHBTMFpaYlNaa2lIS3hJV3phb2pUXzRLTzJyWWpfQw==> DOI: 10.1109/IGARSS39084.2020.9324213

## Description

### CROSS-REFERENCE TO RELATED APPLICATIONS

The present application claims priority to Chinese Patent Application No. 202011295008.7 filed on November 18, 2020.

### TECHNICAL FIELD

The present disclosure generally relates to image processing technology, and more particularly, relates to methods and systems for constructing a building block model.

### BACKGROUND

With the popular application of satellite remote sensing technology, a period of satellite-to-earth visits has been shortened, and the acquisition of remote sensing images with high-resolution has continuously increased. The use of remote sensing satellite images with high-resolution to extract urban buildings and obtain information such as the distribution information, area information, and height information of urban buildings have an important role in evaluating urban building floor area ratio, urban three-dimensional reconstruction, urban land environment assessment, etc.

How to use more advanced methods to extract urban buildings and obtain information about the urban buildings has become a technical problem that needs to be solved urgently. Documents
- TREKIN A N ET AL: "Deep Neural Networks for Determining the Parameters of Buildings from Single-Shot Satellite Imagery", JOURNAL OF COMPUTER AND SYSTEMS SCIENCES INTERNATIONAL, PLEIADES PUBLISHING, MOSCOW, vol. 59, no. 5, 1 September 2020 (2020-09-01), pages 755-767, XP037265157, ISSN: 1064-2307, DOI: 10.1134/ S106423072005007X
- P MEIXNER ET AL: "DESCRIBING BUILDINGS BY 3-DIMENSIONAL DETAILS FOUND IN AERIAL PHOTOGRAPHY", PROCEEDINGS OF ISPRS TC VII SYMPOSIUM - 100 YEARS ISPRS, vol. XXXVIII, 1 January 2010 (2010-01-01), pages 151-156, XP055223065,
- TRIPODI SEBASTIEN ET AL: "Operational Pipeline for Large-Scale 3D Reconstruction of Buildings From Satellite Images", IGARSS 2020, 2020 IEEE INTERNATIONAL GEOSCIENCE AND REMOTE SENSING SYMPOSIUM, 26 September 2020 (2020-09-26), pages 445-448, XP055866131, DOI: 10.1109/IGARSS39084.2020.9324213 ISBN: 978-1-7281-6374-1
- CN 101 290 222 A (BEIJING PEACE MAP CO LTD [CN]) 22 October 2008 (2008-10-22)
- WO 2020/207512 A1 (BEIJING CHENGSHI WANGLIN INFORMATION TECH CO LTD [CN]) 15 October 2020 (2020-10-15)
represent the prior art.

### SUMMARY

The invention is carried out according to the appended claims. According to an aspect of the present disclosure, a method for constructing a building block model is provided. The method may include obtaining a remote sensing image. The method may include obtaining a processing result by processing the remote sensing image using an image processing model. The processing result may include a segmentation result of a top surface of a building in the remote sensing image and feature information of pixels representing the building in the remote sensing image. The method may further include determining a bottom surface of the building in the remote sensing image based on the processing result. The method may further include determining a height of the building in the remote sensing image based on the feature information of the pixels representing the building. The method may further include constructing the building block model based on the bottom surface of the building and the height of the building.

In some embodiments, the feature information of the pixels representing the building may include a pixel height of a building in the remote sensing image and a shooting direction of the remote sensing image.

In some embodiments, the image processing model may include a deep learning network model. The image processing model may include a feature extraction module, a first processing module, and a second processing module. The feature extraction module may be configured to obtain feature data by processing the remote sensing image. The first processing module may be configured to determine the segmentation result of the top surface based on the feature data. The second processing module may be configured to determine feature information of the pixels representing the building in the remote sensing image.

In some embodiments, the first processing module may further be configured to determine a segmentation result of a side surface of the building in the remote sensing image based on the feature data. The second processing module may further be configured to determine the pixel height of the building in the remote sensing image and the shooting direction of the remote sensing image based on the feature data and the segmentation result of the top surface and the side surface of the building.

In some embodiments, the feature extraction module may include a plurality of branches. The plurality of branches may include at least a first branch and a second branch. The dimension of the first branch may be smaller than that of the second branch. The spatial resolution of the first branch may be greater than that of the second branch.

In some embodiments, the determining a bottom surface of the building in the remote sensing image based on the processing result may include determining a height flow vector based on the pixel height of the building in the remote sensing image and the shooting direction of the remote sensing image and determining the bottom surface of the building in the remote sensing image based on the height flow vector. The height flow vector may include a first unit component, a second unit component, and the pixel height of the building.

In some embodiments, the determining the bottom surface of the building in the remote sensing image based on the height flow vector may include determining the bottom surface of the building by mapping the top surface of the building to a bottom of the building based on the height flow vector.

In some embodiments, the constructing the building block model based on the bottom surface of the building and the height of the building may include determining a vectorized representation of a contour of the bottom surface of the building by vectorizing the bottom surface of the building and constructing the building block model of the building based on the height of the building and the vectorized representation of the contour of the bottom surface of the building.

In some embodiments, the processing result may further include the segmentation result of the side surface of the building in the remote sensing image.

According to another aspect of the present disclosure, a system for constructing a building block model is provided. The system may include an image acquisition module, an image processing module, a bottom surface determination module, a height determination module, and a block model constructing module. The image acquisition module may be configured to obtain a remote sensing image. The image processing module may be configured to obtain a processing result by processing the remote sensing image using an image processing model. The processing result may include a segmentation result of a top surface of a building in the remote sensing image and feature information of pixels representing the building in the remote sensing image. The bottom surface determination module may be configured to determine, based on the processing result, a bottom surface of the building in the remote sensing image. The height determination module may be configured to determine, based on the feature information of the pixels representing the building, a height of the building in the remote sensing image. The block model constructing module may be configured to construct, based on the bottom surface of the building and the height of the building, the building block model.

According to another aspect of the present disclosure, a system for constructing a building block model is provided. The system may include at least one storage device including a set of instructions and at least one processor configured to communicate with the at least one storage device. When executing the set of instructions, the at least one processor may be configured to direct the system to perform a method. The method may include obtaining a remote sensing image. The method may include obtaining a processing result by processing the remote sensing image using an image processing model. The processing result may include a segmentation result of a top surface of a building in the remote sensing image and feature information of pixels representing the building in the remote sensing image. The method may further include determining a bottom surface of the building in the remote sensing image based on the processing result. The method may further include determining a height of the building in the remote sensing image based on the feature information of the pixels representing the building. The method may further include constructing the building block model based on the bottom surface of the building and the height of the building.

According to another aspect of the present disclosure, a non-transitory computer readable medium is provided. The non-transitory computer readable medium may include at least one set of instructions. When executed by a computer, the at least one set of instructions may direct the computer to perform a method. The method may include obtaining a remote sensing image. The method may include obtaining a processing result by processing the remote sensing image using an image processing model. The processing result may include a segmentation result of a top surface of a building in the remote sensing image and feature information of pixels representing the building in the remote sensing image. The method may further include determining a bottom surface of the building in the remote sensing image based on the processing result. The method may further include determining a height of the building in the remote sensing image based on the feature information of the pixels representing the building. The method may further include constructing the building block model based on the bottom surface of the building and the height of the building.

According to another aspect of the present disclosure, a method for constructing a building block model based on a remote sensing image is provided. The method may include obtaining the remote sensing image. The remote sensing image may include a plurality of buildings. The method may include obtaining a top surface of a building of the plurality of buildings, a side surface of the building, a pixel height of the building, and a shooting direction of the remote sensing image by inputting the remote sensing image into a network model. The method may further include determining a bottom surface of the building by mapping the top surface of the building to a bottom of the building based on the pixel height of the building and the shooting direction of the remote sensing image. A shape of the top surface of the building may be the same as that of the bottom surface of the building. The method may further include determining an average height of the building in the remote sensing image by using the pixel height of the building. The method may further include constructing the building block model based on the average height and the bottom surface of the building.

In some embodiments, the determining a bottom surface of the building by mapping the top surface of the building to a bottom of the building based on the pixel height of the building and the shooting direction of the remote sensing image may include determining a height flow vector of the building by using the pixel height of the building and the shooting direction of the remote sensing image and determining the bottom surface of the building by mapping the top surface of the building to the bottom of the building based on the height flow vector and the side surface of the building.

In some embodiments, the determining a height flow vector of the building by using the pixel height of the building and the shooting direction of the remote sensing image may include determining a first unit component and a second unit component of the shooting direction of the remote sensing image based on the shooting direction of the remote sensing image and determining the height flow vector based on the first unit component, the second unit component, and the pixel height of the building. The first unit component may be perpendicular to the second unit component.

In some embodiments, the network model may include a feature extraction module and an output module. The feature extraction module and the output module may be sequentially connected. The output module may include a first output module and a second output module. The first output module may include a first convolutional dimension reduction layer and a second convolutional dimension reduction layer. The second output module may include a deconvolution submodule and a convolution residual submodule. An output of the feature extraction module may be an input of the first output module. An output of the first output module may include the top surface of the building, the side surface of the building, and a background of the remote sensing image. An input of the deconvolution submodule in the second output module may be a result of stacking and cascading the first convolution dimension reduction layer and the second convolution dimension reduction layer in the first output module. An output of the deconvolution submodule may be an input of the convolution residual submodule. An output of the convolution residual submodule may include the pixel height of the building in the remote sensing image and the shooting direction of the remote sensing image.

In some embodiments, the feature extraction module may include a plurality of branches. The method may further include obtaining feature layers of the same size corresponding to the plurality of branches by processing a feature layer output by each of the plurality of branches using a bilinear interpolation technology and a cascade technology and obtaining the output of the feature extraction module by processing the feature layers of the same size corresponding to the plurality of branches using a stacked cascade technology.

In some embodiments, after the bottom surface of the building is determined by mapping the top surface of the building to a bottom of the building based on the pixel height of the building and the shooting direction of the remote sensing image, the method may include determining a vectorized representation of a contour of the bottom surface of the building by vectorizing the bottom surface of the building, determining the average height of the building in the remote sensing image by using the pixel heights of the pixels of the top surface of the building, and constructing the building block model based on the average height of the building and the bottom surface of the building.

In some embodiments, the method may further include obtaining true heights of a part of buildings in the remote sensing image, determining a global scale factor of the buildings in the remote sensing image based on the true heights of the part of buildings and the pixel heights of the part of buildings, determining a real height of each building in the remote sensing image based on the global scale factor, and constructing the building block model based on the real height.

According to another aspect of the present disclosure, a device for constructing a building block model is provided. The device may include an acquisition module, a segmentation and extraction model, a mapping module, a calculation module, and a model construction module. The acquisition module may be configured to obtain a remote sensing image. The remote sensing image may include a plurality of buildings. The segmentation and extraction model may be configured to obtain a top surface of a building of the plurality of buildings, a side surface of the building, a pixel height of the building, and a shooting direction of the remote sensing image by inputting the remote sensing image into a network model. The mapping module may be configured to determine a bottom surface of the building by mapping the top surface of the building to a bottom of the building based on the pixel height of the building and the shooting direction of the remote sensing image. A shape of the top surface of the building may be the same as that of the bottom surface of the building. The calculation module may be configured to determine an average height of the building in the remote sensing image by using the pixel height of the building. The model construction module may be configured to construct the building block model based on the average height and the bottom surface of the building.

According to another aspect of the present disclosure, an electronic device is provided. The electronic device may include a memory and a processor coupled to each other. The processor may be configured to execute program instructions stored in the memory to implement the method for constructing a building block model based on a remote sensing image.

According to another aspect of the present disclosure, a computer-readable storage medium is provided. The computer-readable storage medium may include program instructions. When executed by a processor, the program instructions may implement the method for constructing a building block model based on a remote sensing image.

### BRIEF DESCRIPTION OF THE DRAWINGS

The present disclosure is further described in terms of exemplary embodiments. These exemplary embodiments are described in detail with reference to the drawings. The drawings are not to scale. These embodiments are non-limiting exemplary embodiments, in which like reference numerals represent similar structures throughout the several views of the drawings, and wherein:
FIG. 1 is a schematic diagram illustrating an exemplary application scenario of a system for constructing a building block model according to some embodiments of the present disclosure;
FIG. 2 is a flowchart illustrating an exemplary process for constructing a building block model according to some embodiments of the present disclosure;
FIG. 3 is a schematic diagram illustrating an exemplary image processing model according to some embodiments of the present disclosure;
FIG. 4 is an exemplary schematic diagram of determining a bottom surface of a building according to some embodiments of the present disclosure;
FIG. 5 is a schematic diagram illustrating an exemplary system for constructing a building block model according to some embodiments of the present disclosure;
FIG. 6 is a schematic diagram illustrating an exemplary height flow vector according to some embodiments of the present disclosure;
FIG. 7 is a schematic diagram illustrating an exemplary feature extraction model including four branches according to some embodiments of the present disclosure;
FIG. 8 is a schematic diagram illustrating an exemplary remote sensing image according to some embodiments of the present disclosure;
FIG. 9 is a schematic diagram illustrating exemplary segmentation results of buildings according to some embodiments of the present disclosure;
FIG. 10 is a schematic diagram illustrating exemplary extraction results of buildings according to some embodiments of the present disclosure;
FIG. 11 is a schematic diagram illustrating an exemplary vectorization of buildings according to some embodiments of the present disclosure; and
FIG. 12 is a schematic diagram illustrating an exemplary building block model according to some embodiments of the present disclosure.

### DETAILED DESCRIPTION

In order to illustrate the technical solutions related to the embodiments of the present disclosure, a brief introduction of the drawings referred to in the description of the embodiments is provided below. Obviously, the drawings described below are only some examples or embodiments of the present disclosure. Those having ordinary skills in the art, without further creative efforts, may apply the present disclosure to other similar scenarios according to these drawings. Unless stated otherwise or obvious from the context, the same reference numeral in the drawings refers to the same structure and operation.

It will be understood that the term "system," "device," "unit," and/or "module" used herein are one method to distinguish different components, elements, parts, sections, or assembly of different levels in ascending order. However, the terms may be displaced by another expression if they achieve the same purpose.

As used in the disclosure and the appended claims, the singular forms "a," "an," and "the" include plural referents unless the content clearly dictates otherwise. It will be further understood that the terms "comprises," "comprising," "includes," and/or "including" when used in the disclosure, specify the presence of stated steps and elements, but do not preclude the presence or addition of one or more other steps and elements.

According to some embodiments of the present disclosure, flow charts are used to illustrate the operations performed by the system. It is to be expressly understood, the operations above or below may or may not be implemented in order. Conversely, the operations may be performed in inverted order, or simultaneously. Besides, one or more other operations may be added to the flowcharts, or one or more operations may be omitted from the flowchart.

At present, in related technology, methods for obtaining building height based on remote sensing images are mainly divided into two categories: one is to calculate disparity based on stereo relative or multi-view remote sensing images through stereo matching techniques and determine the height of the building by obtaining depth information of each pixel; the other is to use a single remote sensing image to estimate the height of the building based on a remote sensing imaging model or parameters such as building shadow, azimuth of the satellite, azimuth of the sun, and altitude angle.

In order to better automatically segment and extract buildings in remote sensing images, estimate the heights of the buildings, and generate building block models, some embodiments of the present disclosure provide a method for constructing a building block model, which can construct a building block model based on remote sensing images in combination with a building contour segmentation technique.

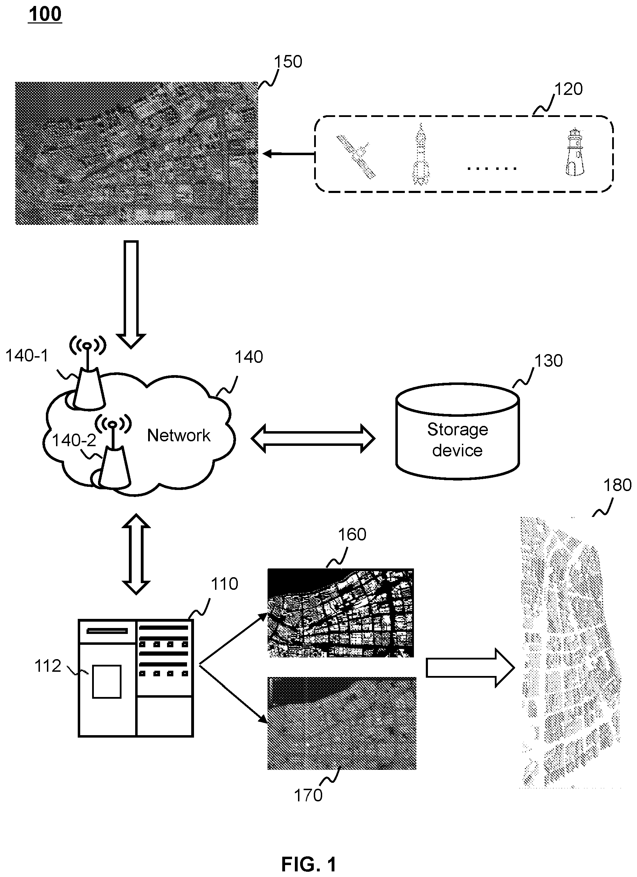

FIG. 1 is a schematic diagram illustrating an exemplary application scenario of a system for constructing a building block model according to some embodiments of the present disclosure.

As shown in FIG. 1, the application scenario 100 may include a server 110, a camera device 120, a storage device 130, and a network 140.

The server 110 may be configured to manage resources and process data and/or information from at least one component of the system or an external data source (e.g., a cloud data center). The server 110 may execute program instructions based on the data, information, and/or processing results to perform one or more functions described in the present disclosure. In some embodiments, the server 110 may be a single server or a server group. The server group may be centralized or distributed (e.g., the server 110 may be a distributed system). The server group may be dedicated or be served by other devices or systems at the same time. In some embodiments, the server 110 may be local or remote. In some embodiments, the server 110 may be implemented on a cloud platform. Merely by way of example, the cloud platform may include a private cloud, a public cloud, a hybrid cloud, a community cloud, a distributed cloud, an inter-cloud, a multi-cloud, or the like, or any combination thereof.

The server 110 may include a processing device 112. The processing device 112 may process data and/or information obtained from other devices or other components of the system. The processing device 112 may execute program instructions based on the data, information, and/or processing results to perform one or more functions described in the present disclosure. For example, the processing device 112 may process a remote sensing image 150 based on an image processing model to obtain a processing result. In some embodiments, the processing result may include a segmentation result 160 of a top surface of a building in the remote sensing image and feature information 170 of pixels corresponding to the top surface of the building in the remote sensing image. In some embodiments, the segmentation result 160 may include a side surface of the building. As another example, the processing device 112 may obtain a building block model 180 based on the processing result. In some embodiments, the processing device 112 may include one or more sub-processing devices (e.g., single-core processing device(s) or multi-core processing device(s)). Merely by way of example, the processing device 112 may include a central processing unit (CPU), an application-specific integrated circuit (ASIC), an application-specific instruction-set processor (ASIP), a graphics processing unit (GPU), a physics processing unit (PPU), a digital signal processor (DSP), a field-programmable gate array (FPGA), a programmable logic device (PLD), a controller, a microcontroller unit, a reduced instruction-set computer (RISC), a microprocessor, or the like, or any combination thereof. In some embodiments, the processing device 112 may be integrated into the server 110 or the camera device 120.

In some embodiments, the processing device 112 may be implemented on a computing device. The computing device may include COM ports 250 connected to and from a network connected thereto to facilitate data communications. The computing device may also include a processor, in the form of one or more processors (e.g., logic circuits), for executing program instructions. For example, the processor may include interface circuits and processing circuits therein. The interface circuits may be configured to receive electronic signals from a bus, wherein the electronic signals encode structured data and/or instructions for the processing circuits to process. The processing circuits may conduct logic calculations, and then determine a conclusion, a result, and/or an instruction encoded as electronic signals. Then the interface circuits may send out the electronic signals from the processing circuits via the bus. The computing device may further include program storage and data storage of different forms including, for example, a disk, a read-only memory (ROM), or a random-access memory (RAM), for storing various data files to be processed and/or transmitted by the computing device. The computing device may also include program instructions stored in the ROM, RAM, and/or another type of non-transitory storage medium to be executed by the processor. The methods and/or processes of the present disclosure may be implemented as the program instructions. The computing device may also include an I/O component, supporting input/output between the computing device and other components. The computing device may also receive programming and data via network communications.

The camera device 120 may be configured to capture images or videos. For example, the camera device 120 may be configured to obtain the remote sensing image 150. The camera device 120 may include a camera, a visible light infrared sensor, an electromagnetic wave sensor, or the like, or any combination thereof. In some embodiments, the camera device 120 can be carried by any mobile or fixed platform such as, including but not limited to artificial satellites, manned aerospace, space stations, airplanes, drones, balloons, vehicles, towers, etc.

The storage device 130 may be configured to store data and/or instructions. The storage device 130 may include one or more storage components, and each storage component may be an independent device or a part of other devices. For example, the storage device 130 may be integrated into the server 110 or the camera device 120. In some embodiments, the storage device 130 may include a random access memory (RAM), a read-only memory (ROM), a mass storage, a removable storage, a volatile read-and-write memory, or the like, or any combination thereof. Exemplary mass storage may include a magnetic disk, an optical disk, a solid-state disk, etc. Data refers to digital representation of information which may include various types. For example, the data may include binary data, text data, image data, video data, etc. Instructions refer to programs that can control equipment or devices to perform specific functions. In some embodiments, the storage device 130 may be implemented on a cloud platform.

The network 140 may connect various components of the system and/or connect the system and external resources. The network 140 may enable communication between various components of the system and/or the system and external parts and facilitate the exchange of information and/or data. In some embodiments, the network 140 may be any type of wired or wireless network, or any combination thereof. Merely by way of example, the network 140 may include a cable network, a wireline network, an optical fiber network, a telecommunications network, an intranet, an internet, a local area network (LAN), a wide area network (WAN), a wireless local area network (WLAN), a metropolitan area network (MAN), a wide area network (WAN), a public telephone switched network (PTSN), a Bluetooth network, a ZigBee network, a near field communication (NFC) network, or the like, or any combination thereof. The network connection between the various parts may be implemented in one or more of the above-mentioned ways. In some embodiments, the network may include topological structures such as a point-to-point structure, a shared structure, a central structure, or the like, or any combination thereof. In some embodiments, the network 140 may include one or more network access points. For example, the network 140 may include wired or wireless network access points such as base stations and/or internet exchange points 140-1, 140-2, ..., through which one or more components of the system may be connected to the network 140 to exchange data and/or information.

The server 110 may be connected to the processing device 112, the camera device 120, and the storage device 130 to obtain data and/or information via the network 140. The server 110 may execute program instructions based on the acquired data, information, and/or processing results, so as to realize the construction of the building block model. The storage device 130 may store various data and/or information in the operations of the method for constructing a building block model. The description of the information transfer relationship between various components of the system may be provided for illustration purposes, and not intended to limit the scope of the present disclosure.

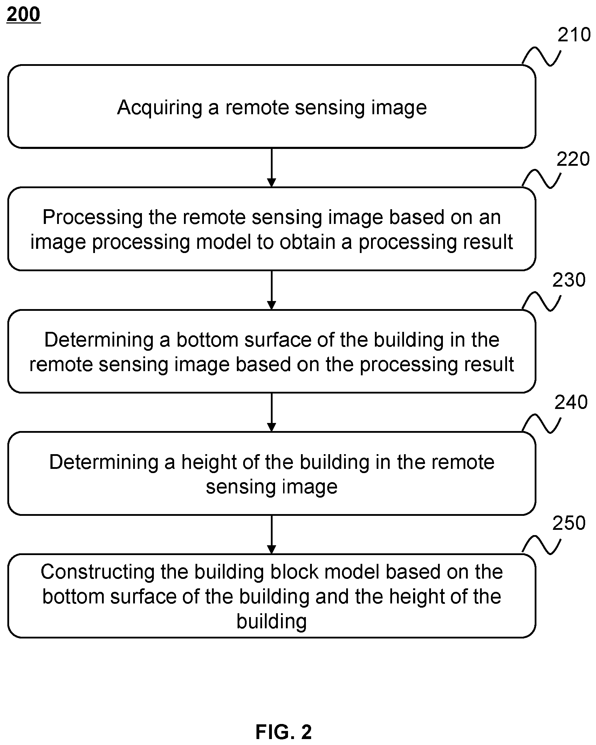

FIG. 2 is a flowchart illustrating an exemplary process for constructing a building block model according to some embodiments of the present disclosure. In some embodiments, the process 200 may be implemented by a processing device (e.g., the server 110 or the processing device 112). The process 200 may be stored in a storage device (such as a built-in storage unit of the processing device or an external storage device) in the form of a program or instruction. When the program or instruction is executed, the process 200 may be implemented. The process 200 may include the following operations.

In 210, a remote sensing image may be acquired. In some embodiments, the operation 210 may be performed by the processing device 112 (e.g., an image acquisition module 510).

A remote sensing image refers to an image obtained by acquiring characteristic information of a target object through a sensor mounted on a certain platform without direct contact with the target object. According to the type of platform on which the sensor is mounted, a remote sensing image may include a satellite remote sensing image, an aerial remote sensing image, a ground remote sensing image (for example, an image acquired by a sensor mounted on the platform such as a vehicle, an elevated, or an unmanned aerial), etc.

In some embodiments, the remote sensing image may include a visible light remote sensing image, an ultraviolet remote sensing image, an infrared remote sensing image, a microwave detection remote sensing image, or the like.

In some embodiments, the remote sensing image may be acquired by the camera device (e.g., the camera device120). In some embodiments, the sensor may be integrated into a camera, also be referred to as a camera device. More descriptions for the camera device may be found elsewhere in the present disclosure (e.g., FIG. 1 and the descriptions thereof).

In some embodiments, the sensor may include a visible light sensor, an ultraviolet sensor, an infrared sensor, a microwave detection sensor, or the like, mounted on various platforms.

In some embodiments, the processing device 112 may obtain the remote sensing image by calling data from a storage device, a database, or related data interfaces. In some embodiments, the processing device 112 may obtain the remote sensing image from the sensor.

In 220, the remote sensing image may be processed based on an image processing model to obtain a processing result. In some embodiments, the operation 220 may be performed by the processing device 112 (e.g., an image processing module 520).

The image processing model may be configured to process the remote sensing image. The image processing model may include a neural network model, a deep learning model, a machine learning model with custom structures, or the like.

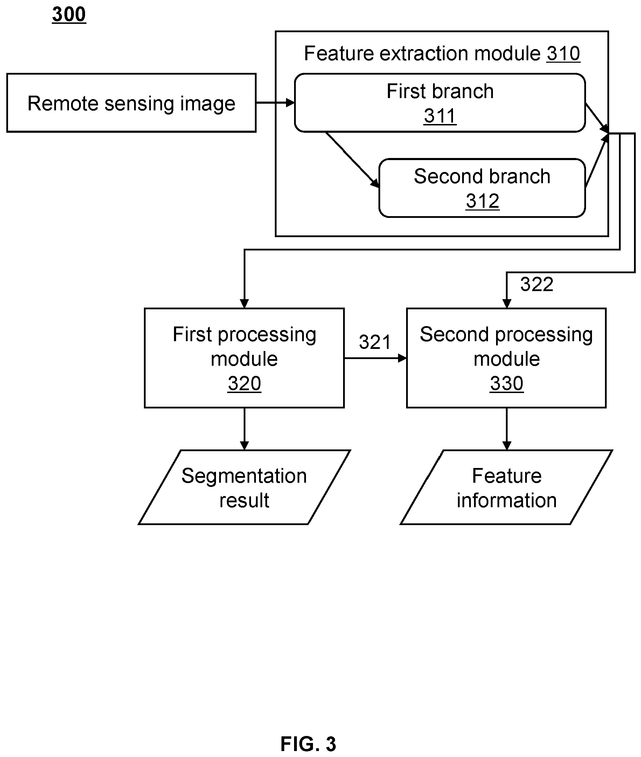

In some embodiments, the image processing model may be a model with a custom structure. The image processing model with the custom structure may include a feature extraction module, a first processing module, and a second processing module. More descriptions regarding the image processing model with the custom structure may be found elsewhere in the present disclosure. See, e.g., FIG. 3 and the relevant descriptions thereof.

The processing result may be a prediction result of a prediction target output after the remote sensing image is processed by the image processing model. The prediction target may include a building segmentation, a building height, a shooting direction of remote sensing image, or the like.

In some embodiments, the processing result may include a segmentation result of a top surface of a building in the remote sensing image and feature information of pixels corresponding to the building in the remote sensing image.

The top surface of the building refers to an area composed of pixels representing the top of the building in the remote sensing image. In some embodiments, the top surface of the building in the remote sensing image may be composed of a plurality of pixels, and the area and contour of the top surface of the building may be represented by the plurality of pixels.

The segmentation result of the top surface of the building may include pixels corresponding to the top surface of the building segmented or distinguished from all the pixels of the remote sensing image. In some embodiments, the segmentation result of the top surface of the building may be the result of pixels classification by the image processing model. For example, a certain pixel may be classified as a pixel corresponding to the top surface of the building or a pixel not corresponding to the top surface of the building.

The feature information may include information that reflects pixel height information of the building in the remote sensing image and/or relative position information between the building and other objects. In some embodiments, the feature information may include positions of the pixels corresponding to the building in the remote sensing image, the pixel height of the building, and a relative angle between the sensor and the building when the remote sensing image is acquired.

In some embodiments, the feature information of the pixels corresponding to the building may include a pixel height of the building in the remote sensing image and a shooting direction of the remote sensing image. The feature information may reflect the pixel height of the building in the remote sensing image and a tilt direction of the building under the shooting direction of the remote sensing image.

The pixels corresponding to the building refer to pixels representing the building in the remote sensing image. In some embodiments, the pixels corresponding to the building may be determined based on the segmentation result of the building in the remote sensing image (e.g., the segmented top surface of the building) by the image processing model. For example, the segmentation result may indicate pixels corresponding to the building or pixels corresponding to an object other than the building (e.g., a road, a green plant, etc.).

The pixel height of the building refers to a length of pixels representing the building in a height direction in the remote sensing image. In a remote sensing image, the height of a building may be related to pixels corresponding to the building. For example, one pixel may represent a certain length in the image, and a total length of a plurality of pixels may represent the pixel height of the building.

In some embodiments, the pixel height of the building may be represented by a count of corresponding pixels. For example, for an image with a resolution of 100 DPI, a length of 1 inch contains 100 pixels. 1 cm is approximately equal to 0.3937 inches. Therefore, for an image with a resolution of 100 DPI, a length of 1 cm contains approximately 39.37 pixels. According to the conversion relationship between the length and the count of pixels, the pixel height of the building may be determined by determining the count of pixels in the height direction of the building.

The shooting direction of the remote sensing image refers to an angle between the sensor and the building during imaging or a tilt direction of the building in the remote sensing image. For example, the shooting direction of the remote sensing image may be the angle between a sensing direction of the sensor and the vertical direction. The height direction of the building may be considered to be perpendicular to the ground. When there is an angle between the sensing direction of the sensor and the height direction of the building, the angle may be decomposed. For example, the angle may be decomposed into a horizontal direction and a vertical direction. The shooting direction of the remote sensing image may be determined based on the decomposition result of the angle.

In some embodiments, when the remote sensing image is shot, the sensor may be far away from the ground, which is similar to being shot with parallel light. In this case, the tilt direction of the building in the image shot by the sensor may be considered to be only one direction, that is, the shooting direction of the remote sensing image has only one direction.

In some embodiments, the remote sensing image may be obtained by stitching a plurality of sub-remote sensing images shot by different sensors. Each of the plurality of sub-remote sensing images may correspond to a shooting direction. In this case, the shooting direction of the remote sensing image may have a plurality of directions.

In some embodiments, the processing result may include the segmentation result of the top surface of the building and a segmentation result of a side surface of the building in the remote sensing image.

The side surface of the building in the remote sensing image may be denoted by pixels representing the side of the building in the remote sensing image. In some embodiments, the side surface of the building in the remote sensing image may be composed of a plurality of pixels, and the area and contour of the side surface (also referred to as a side contour) of the building may be represented by the plurality of pixels.

The segmentation result of the side surface of the building refers to pixels corresponding to the side surface of the building segmented from all the pixels of the remote sensing image. In some embodiments, the segmentation result of the side surface of the building may be the result of pixels classification by the image processing model. For example, a certain pixel may be classified as a pixel corresponding to the side surface of the building or a pixel not corresponding to the side surface of the building.

In some embodiments, the segmentation result of the side surface of the building may play a role to constrain the height prediction. Specifically, when determining the pixel height of the building, the pixels that can be used to represent the height of the building may be generally within the side contour of the building. If pixels are not within the side contour of the building, the processing device 112 may not use the pixels to determine the pixel height of the building. Therefore, the segmentation result of the side surface of the building may be configured to restrict or optimize the height prediction of the building. In some embodiments, the segmentation result of the side surface of the building may be configured to verify the height prediction, for example, to verify whether the pixels for predicting the height are located in the side contour of the building. More descriptions regarding the side surface of the building may be found elsewhere in the present disclosure. See, e.g., FIG. 3 and the relevant descriptions thereof.

In some embodiments, the processing device 112 may input the remote sensing image into the image processing model, and the image processing model may output the segmentation result of the top surface of the building, the segmentation result of the side surface of the building, and the feature information of the pixels corresponding to the building. For example, the image processing model may classify each pixel in the remote sensing image to determine the position of each pixel corresponding to the top surface or the side surface of the building in the remote sensing image. As another example, the image processing model may determine the pixel height of the building by determining the height of the pixels representing the building in the remote sensing image and predict the shooting direction of the remote sensing image (i.e., the tilt direction of the building) based on the pixel.

In some embodiments, the image processing model may include a feature extraction module, a first processing module, and a second processing module. After the remote sensing image is inputted into the image processing model, the remote sensing image may be processed by the feature extraction module to extract the feature data. The segmentation result of the top surface of the building, the segmentation result of the side surface of the building, the pixel height of the building, and the prediction result of the shooting direction of the remote sensing image may be obtained based on the processing of the feature data by the first processing module and the second processing module.

More descriptions regarding processing the remote sensing image using the image processing model may be found elsewhere in the present disclosure. See, e.g., FIG. 3 and the relevant descriptions thereof.

In 230, a bottom surface of the building in the remote sensing image may be determined based on the processing result. In some embodiments, the operation 230 may be performed by the processing device 112 (e.g., a bottom surface determination module 530).

The bottom surface of the building refers to a projection surface of the part of the building in contact with the ground. In some embodiments, a contour of the bottom surface of the building may be determined by the exterior wall or the structure periphery of the building. In some embodiments, the building may be substantially perpendicular to the ground. To a certain extent, the processing device 112 may consider that an area and contour obtained by projecting the top surface of the building to the ground from a direction perpendicular to the top surface of the building are the same as that of the bottom surface of the building.

In some embodiments, the top surface of the building may be the same as the bottom surface of the building.

In some embodiments, the processing device may determine the bottom surface of the building by translation transformation based on the segmentation result of the top surface of the building, the pixel height of the building, and the prediction result of the shooting direction of the remote sensing image. For example, the processing device may move the top surface of the building along the shooting direction of the remote sensing image by a distance equal to the pixel height of the building. The position of the top surface of the building after being moved may be that of the bottom surface of the building.

Merely by way of example, the processing device may determine the bottom surface of the building in the manner described in the following embodiments.

In some embodiments, the processing device may determine the bottom surface of the building by mapping the top surface of the building to the bottom of the building based on a height flow vector.

The height flow vector refers to a vector representing the height and direction of the building in the remote sensing image. The height flow vector may reflect the tilt angle of the building and the pixel height of the top surface of the building in the remote sensing image.

In some embodiments, the height flow vector may be represented by dense pixel-level encoding HeightFlow (sinθ, cosθ, Magnitude), where θ ∈ [0, 2π]. The remote sensing image may contain three channels, respectively representing a y unit component (vertical direction), an x unit component (horizontal direction) of the shooting direction of each pixel in the remote sensing image, and a pixel height (scale) of each pixel in the remote sensing image. The use of the height flow vector may prevent the image processing model from directly predicting the angular direction of the pixel, but uses [-1, 1] to perform direction regression, thereby increasing the accuracy of the prediction.

In some embodiments, the height flow vector may be determined based on the pixel height of the building in the remote sensing image and the shooting direction of the remote sensing image. The height flow vector may include a first unit component, a second unit component, and the pixel height of the building.

The first unit component refers to a vertical component of the shooting direction of the pixel. For example, the first unit component may be the y unit component mentioned above.

The second unit component refers to a horizontal component of the shooting direction of the pixel. For example, the second unit component may be the x unit component mentioned above.

The pixel height of the building refers to a length of pixels representing the building in a height direction in the remote sensing image. For example, the pixel height of the building may be the pixel height (scale) mentioned above.

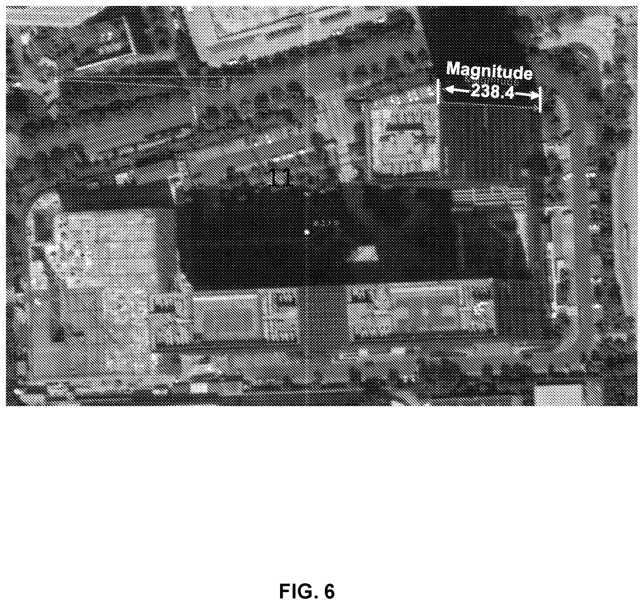

Merely by way of example, an exemplary schematic diagram of the height flow vector may be shown in FIG. 6. The one-way arrow in FIG. 6 may represent the height flow vector. The angle θ may represent the angle between the height flow vector and the horizontal direction, which may be decomposed to obtain the first unit component in the vertical direction and the second unit component in the horizontal direction. The Magnitude in FIG. 6 may represent the pixel height of the height flow vector, and the length 238.4 of the Magnitude may be the pixel height of the building.

In some embodiments, the processing device may determine the first unit component and the second unit component of the shooting direction of the remote sensing image based on the shooting direction of the remote sensing image. The first unit component and the second unit component may be perpendicular to each other.

The processing device may determine the height flow vector of the building based on the first unit component, the second unit component, and the pixel height of the building.

Specifically, the processing device may determine the direction of the height flow vector of the building based on the first unit component and the second unit component, and determine the magnitude of the height flow vector based on the pixel height of the building. The height flow vector may be obtained by expressing the direction of the height flow vector and the magnitude of the height flow vector in the form of (sinθ, cosθ, Magnitude).

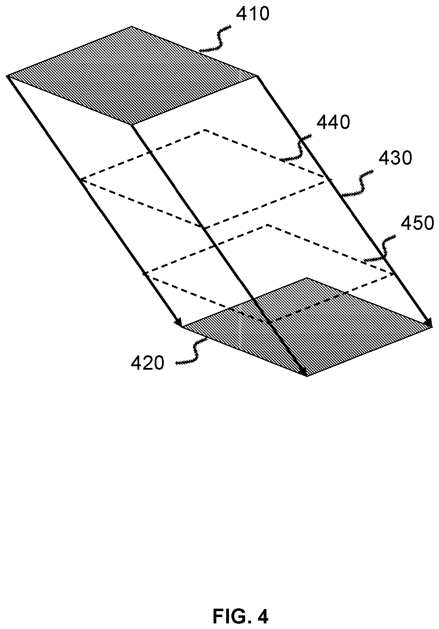

After the height flow vector is determined, the bottom surface of the building may be obtained by moving the top surface of the building along the height flow vector. For example, as shown in FIG. 4, which is an exemplary schematic diagram of determining a bottom surface of a building according to some embodiments of the present disclosure. The top surface 410 of the building may be translated based on the height flow vector 430 to determine the bottom surface 420 of the building. Specifically, the moving direction of the top surface of the building may be the direction of the height flow vector 430 (the direction of the arrow in FIG. 4), and the moving distance may be the length of the height flow vector 430. For illustration purposes, the dashed boxes 440 and 450 may represent the top surface of the building during the translation.

In 240, a height of the building in the remote sensing image may be determined based on the feature information of the pixels corresponding to the building. In some embodiments, the operation 240 may be performed by the processing device 112 (e.g., a height determination module 540).

A height of the building refers to the height of the building with respect to another object (e.g., a road, a tree) in the remote sensing image (also referred to as a pixel height of the building). For example, the height of the building may be the pixel height of the building under the scale of the remote sensing image. The pixel height of the building may be an average height of a building in the remote sensing image.

In some embodiments, the height of the building may also be referred to as a real height of the building in the remote sensing image in the physical world.

In some embodiments, the processing device may determine the pixel height or the true height of the building based on the feature information of the pixels corresponding to the building.

In some embodiments, the processing device may directly use the pixel height of the building as the pixel height of the building. In some embodiments, the processing device may determine the average height of the building based on the pixel height of each of the pixels corresponding to the building. For example, considering that the pixel height of each of the pixels corresponding to the top of the building output by the image processing model may have a prediction error, even if the pixels are pixels corresponding to the top of the same building, their corresponding pixel heights may not be consistent. In order to improve the accuracy of the extraction of the building, the system for constructing a building block model may obtain the average height of the building by averaging the pixel heights of the pixels corresponding to the top surface of the building.

In some embodiments, the real height of the building may be obtained based on the pixel height or average height of the building and a global scale factor. The global scale factor refers to a proportional relationship between a size of an object in the remote sensing image and a size of an object in the real physical world.

Merely by way of example, the processing device may determine the real height of the building in the manner described in the following embodiments.

The processing device may obtain the real heights of a plurality of buildings in the remote sensing image. In some embodiments, the processing device may recognize the names of some of the plurality of buildings from the remote sensing image by means of image recognition or the like and obtain the real heights of some of the plurality of buildings by means of a network query or the like. In some embodiments, the names of some of the plurality of buildings may be recognized from the remote sensing image by means of manual recognition and the real heights of some of the plurality of buildings may be obtained.

The processing device may obtain the global scale factor of the building in the remote sensing image based on the real heights and the pixel heights of some of the plurality of buildings. For example, the processing device may obtain the global scale factor by dividing the pixel height of a building by the real height of the building.

The processing device may determine the real height of each building in the remote sensing image based on the global scale factor. For example, the processing device may obtain the real height by multiplying the pixel height of each building in the remote sensing image by the global scale factor. The real height may be used to construct a building block model.

In 250, the building block model may be constructed based on the bottom surface of the building and the height of the building. In some embodiments, the operation 250 may be performed by the processing device 112 (e.g., a block model constructing module 550).

The building block model refers to a three-dimensional model that abstracts the building body and simulates the distribution of the building.

In some embodiments, the processing device may obtain a vectorized representation of the contour of the bottom surface of the building by vectorizing the bottom surface of the building. The vectorized representation refers to a representation of the contour of the bottom surface of the building in the form of a vector. Considering that after the top surfaces of a plurality of buildings are mapped to the bottom positions of the plurality of buildings, the bottom surfaces of the plurality of buildings may be side by side, and it is difficult to distinguish the bottom surface of each building. Therefore, after the bottom surface of the building is obtained, the bottom surface of the building may be vectorized. Specifically, the processing device may use the contour of the bottom surface of the building to divide the connected area on the bottom surface of the building and vectorize each divided connected area to obtain a vectorized representation of the contour of the bottom surface of the building. The connected area refers to an area where two adjacent buildings are connected.

The processing device may construct the building block model based on the height of the building and the contour of the bottom surface of the building. For example, the processing device may determine the average height of each building in the remote sensing image by using the pixel height of each of the pixels corresponding to the top surface of the building. The processing device may construct a structure based on the average height of each building and the contour of the bottom surface of the building. For example, the building block model may be constructed by giving a block to a space composed of the top surface of the building, the bottom surface of the building, and the height of the building.

In some embodiments of the present disclosure, the method for constructing a building block model may include acquiring a remote sensing image, inputting the remote sensing image into an image processing model to obtain a top surface of a building, a side surface of the building, a pixel height of the building, and a shooting direction of the remote sensing image, determining a bottom surface of the building in the remote sensing image by mapping the top surface of the building to a bottom of the building based on the pixel height of the building and the shooting direction of the remote sensing image, determining a height of the building in the remote sensing image based on the pixel height of each of the pixels corresponding to the top surface of the building, and constructing the building block model based on the height of the building and the bottom surface of the building. In the above process, the pixel height of the building may be extracted by using the remote sensing image without using other external files, and the top surface of a building, the side surface of the building, the pixel height of the building, and the shooting direction of the remote sensing image may be obtained by using the image processing model to process the input remote sensing image. Compared with the traditional method of building extraction and the manual method of selecting buildings to calculate the height, the method provided in the present disclosure may effectively improve the extraction accuracy and efficiency.

It should be noted that the above description about process 200 is merely provided for the purposes of illustration, and not intended to limit the scope of the present disclosure. For persons having ordinary skills in the art, multiple variations and modifications to process 200 may be made under the teachings of the present disclosure. However, those variations and modifications do not depart from the scope of the present disclosure. For example, at least one storage operation may be added between operations of process 200.

FIG. 3 is a schematic diagram illustrating an exemplary image processing model according to some embodiments of the present disclosure.

As shown in FIG. 3, the image processing model 300 may include a feature extraction module 310, a first processing module 320, and a second processing module 330.

The feature extraction module 310 may be configured to obtain feature data by processing the remote sensing image.

The feature data refers to data extracted from the remote sensing image that contain various types of information of the remote sensing image. For example, the feature data may include semantic information, image features, etc.

In some embodiments, the feature data may be a feature layer obtained after the feature extraction module processes the remote sensing image.

In some embodiments, the feature extraction module may include an input layer and a feature output layer. The input layer may adjust the size and dimensions of the remote sensing image by convolving the remote sensing image. For example, the processing device may input the remote sensing image into the input layer according to a count of image channels (e.g., three channels). The input layer may down-sample the input remote sensing image to 1/4 of the original image size through two convolutions with a step size of 3×3, and the feature output layer with a dimension of 64 may be used for feature extraction.

In some embodiments, the feature extraction module may include 1×1, 3×3, and 1×1 convolution residual modules that are repeatedly stacked 4 times and a 3×3 convolution with a step size of 1. An output dimension of the feature extraction module may be 32. After the feature layer is convolved, the count of channels corresponding to the feature layer of the image may change accordingly. The dimensions refer to the channels of the image after the feature layer is convolved.

The output of the feature extraction module may include the feature data.

In some embodiments, the feature extraction module 310 may include a plurality of branches. For example, the feature extraction module 310 may include a first branch, a second branch, a third branch, a fourth branch, a fifth branch, etc.

A branch refers to a sub-module or a sub-layer of the feature extraction module. Each branch may represent a sub-module or a sub-layer of the feature extraction module.

In some embodiments, the plurality of branches may include a first branch 311 and a second branch 312.

The first branch 311 refers to a first sub-module or a first sub-layer of the feature extraction module.

The first branch 312 refers to a second sub-module or a second sub-layer of the feature extraction module.

In some embodiments, a structure of the first branch 311 may be different from that of the second branch 312. In some embodiments, a dimension of the first branch may be smaller than that of the second branch, and a spatial resolution of the first branch may be greater than that of the second branch.

The spatial resolution refers to a size of the smallest unit in a remote sensing image that can be distinguished in detail, or a measure of the smallest angular linear distance at which a sensor can distinguish two targets. The spatial resolution may reflect the ability to recognize and distinguish two very close targets.

In some embodiments, the spatial resolution of the first branch may be 1/4 of the original image size. In some embodiments, the output dimension of the first branch may be 32. In some embodiments, the spatial resolution of the second branch may be 1/8 of the original image size. In some embodiments, the output dimension of the second branch may be 64.

In some embodiments, as the count of branches of the feature extraction module increases, the dimensions may increase correspondingly and the spatial resolution may decrease correspondingly. The lower the spatial resolution, the smaller the image size, the richer the semantic information the image contains, and the larger the corresponding dimension.

Different branches may be configured to process images with different sizes and spatial resolutions.

In some embodiments, the feature extraction module 310 may also include a third branch, a fourth branch, etc. The count of branches of the feature extraction module may not be limited in the present disclosure.

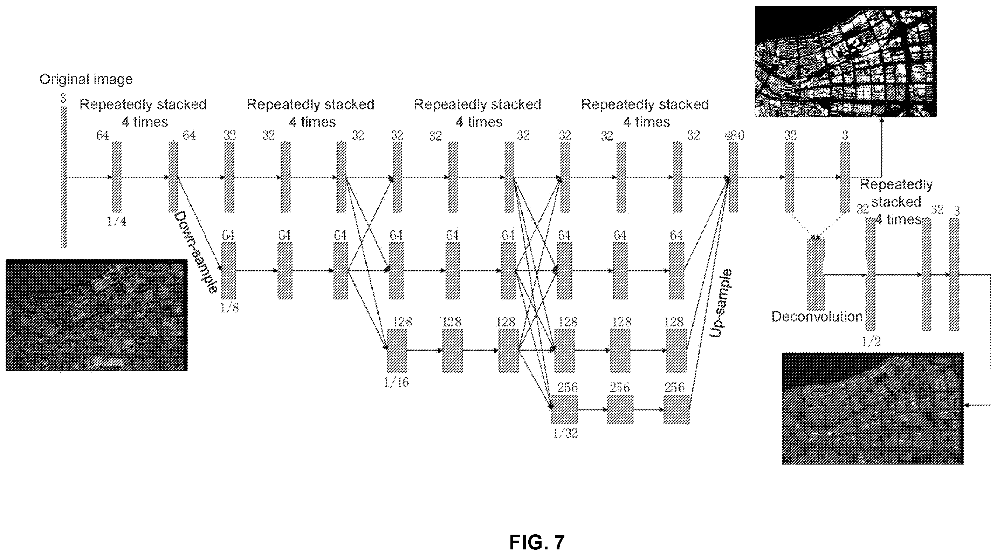

For example, the feature extraction module may include four branches (i.e., the first branch, the second branch, the third branch, and the fourth branch). The input layer may down-sample the input image to 1/4 of the original size through two 3×3 convolutions with a step size of 2, and the output dimension of the input layer may be 64. The first branch structure may include 3×3, 3×3 convolution residual modules that are repeatedly stacked 4 times, and the output dimension of the first branch may be 32. The second branch structure may include 3×3, 3×3 convolution residual modules that are repeatedly stacked 4 times, and the output dimension of the second branch may be 64. The third branch structure may include 3×3, 3×3 convolution residual modules that are repeatedly stacked 4 times, and the output dimension of the third branch may be 128. The fourth branch structure may include 3×3, 3×3 convolution residual modules that are repeatedly stacked 4 times, and the output dimension of the fourth branch may be 256. The feature layers of the output of the four branches may be up-sampled and dimension reduced by using bilinear interpolation and cascaded 1×1 convolution with a step size of 1 to obtain four sets of features with a dimension of 32 and a width and height of 1/4 of the original image. A feature layer with a dimension of 480 may be obtained by performing a feature layer stacking cascade operation on the four sets of features. The stacking operation refers to setting up a plurality of identical convolution modules. The feature extraction may be performed after the plurality of identical convolution modules are stacked. Merely by way of example, an exemplary schematic diagram of the feature extraction model including four branches may be shown in FIG. 7.

In the above example, compared with the original input remote sensing image, the size of the image output by the fourth branch may be 1/32 of the original size, and the dimension may be 256. At this time, the fourth branch may extract basically all the high-level semantic information and the information contained in the spatial resolution. That is, the detailed information of the image output by the fourth branch may be relatively small, and more detailed information may be retained in the branches such as the 32-dimension, 64-dimension, and 128-dimension (i.e., the first branch, the second branch, and the third branch) with a relatively large resolution. The final required feature data may be obtained by merging the extraction results of all the branches together. By setting multiple branches, feature layers with different dimensions may be extracted from images with different sizes and spatial resolutions through different branches. By merging the feature layers with different dimensions, richer image semantic information and more accurate image detail information may be extracted, thereby making the final prediction result more accurate.

In some embodiments, when the feature extraction module includes only one branch, the output of the feature extraction module processing the image may be directly used as the feature data. For example, when the feature extraction module only includes the first branch, the output of the first branch may be used as the feature data. When the feature extraction module includes a plurality of branches, the outputs of the plurality of branches may be merged and the merged result may be used as the feature data. Merging may refer to combining the outputs of the plurality of branches.

The feature data output by the feature extraction module 310 may be the input of the first processing module 320.

The first processing module 320 may be configured to determine the segmentation result of the top surface of the building based on the feature data.

More descriptions regarding the segmentation result of the top surface of the building may be found elsewhere in the present disclosure. See, e.g., FIG. 2 and the relevant descriptions thereof.

In some embodiments, the input of the first processing module 320 may be the feature data, and the output of the first processing module 320 may be the segmentation result of the top surface of the building.

In some embodiments, the output of the first processing module 320 may be in a form of a matrix, and the positions of the elements in the matrix may correspond to the positions of the pixels of the remote sensing image one-to-one. In some embodiments, the elements in the matrix may correspond to three classification results of pixels of the remote sensing image, for example, pixels corresponding to the top surface, pixels corresponding to the side surface, and pixels corresponding to other objects. Each element in the matrix may have its corresponding classification result, and the top surface of the building may be segmented from the remote sensing image based on the classification results.

It can be understood that since the classification result may include the segmentation result of the side surface of the building, in some embodiments, the first processing module 320 may also output the segmentation result of the side surface of the building after processing the feature data.

Merely by way of example, the first processing module 320 may perform a 3×3 convolution to reduce the dimension of the 480-dimensional feature layer (which may be extracted by the feature extraction module including four branches in the above example) to 32 dimensions, and then perform a 1×1 convolution to reduce the 32 dimensions to 3 dimensions. The first processing module 320 may output the segmentation results of the top surface and the side surface of the building as a multi-classification result, which may be supervised by loss.

In some embodiments, the second processing module 330 may be configured to determine the pixel height of the building in the remote sensing image and the shooting direction of the remote sensing image based on the feature data.

More descriptions regarding determining the pixel height of the building in the remote sensing image and the shooting direction of the remote sensing image may be found elsewhere in the present disclosure. See, e.g., FIG. 2 and the relevant descriptions thereof.

In some embodiments, the input of the second processing module 330 may be obtained based on the feature data. For example, in some embodiments, a partial result of the feature data processed by the first processing module 310 may be used as the input of the second processing module 330, and the output of the second processing module 330 may be feature information of the pixels corresponding to the building, such as the pixel height of the building and the shooting direction of the remote sensing image.

In some embodiments, the second processing module 330 may also be configured to determine the pixel height of the building in the remote sensing image and the shooting direction of the remote sensing image based on the feature data and the segmentation result of the top surface and the side surface of the building.

Merely by way of example, still using the above example, the first processing module 320 may perform convolutional dimension reduction for two times on the 480-dimensional feature layer. After the first convolutional dimension reduction, the feature layer may have a dimension of 32, and after the second convolutional dimension reduction, the feature layer may have a dimension of 3. Both the feature layer with a dimension of 32 and the feature layer with a dimension of 3 may be used as the input of the second processing module 330. That is, the feature layer obtained by processing the feature data by the first processing module 320 may be used as the input of the second processing module 330.

The feature layer with a dimension of 3 may represent the segmentation result of the top surface and the side surface of the building by the first processing module 320. The segmentation result may be stacked and cascaded with the features of the previous layer (i.e., the feature layer 32 obtained by processing the feature data by the first processing module 320), and jointly used as the input of the second processing module 330. For example, the feature layer with a dimension of 32 and the feature layer with a dimension of 3 output by the first processing module 320 may be input into the second processing module 330 through operation 321. The second processing module 330 may cascade the 3×3 and 3×3 convolution residual modules that are repeatedly stacked 4 times, perform a 1×1 convolution to reduce the dimension to 3, and output the pixel height of the building in the remote sensing image and the shooting direction of the remote sensing image.

In some embodiments, in the process of determining the pixel height of the building in the remote sensing image and the shooting direction of the remote sensing image by the second processing module 330, the segmentation result of the top surface and the side surface of the building output by the first processing module 320 may be used to constrain the height prediction. Since the height of the building may usually be reflected by the side surface (facade) of the building, using the segmentation result of the top surface and the side surface of the building output by the first processing module 320 to constrain the height prediction may optimize and verify the height prediction, optimize the prediction results of the height of the building and the shooting direction of the image, and improve the accuracy of the model prediction.

In some embodiments, the feature data may be directly used as the input of the second processing module 330 and the second processing module 330 may output the pixel height of the building and the shooting direction of the remote sensing image. As shown in FIG. 3, the arrow 322 may indicate that the feature data extracted by the feature extraction module may be directly used as the input data of the second processing module.

It should be noted that the above descriptions of the image processing model are merely provided for the purposes of illustration, and not intended to limit the scope of the present disclosure. For persons having ordinary skills in the art, multiple variations and modifications to the image processing model may be made under the teachings of the present disclosure. However, those variations and modifications do not depart from the scope of the present disclosure. For example, the image processing model may be divided into two models. The first model may include a feature extraction module and a first processing module. The feature extraction module may be configured to extract features, and the first processing module may be configured to predict the segmentation result of the top surface and the side surface of the building based on the extracted features. The second model may include a feature extraction module and a second processing module. The feature extraction module may be configured to extract features, and the second processing module may be configured to predict the pixel height of the building and the shooting direction of the remote sensing image based on the extracted features.

In some embodiments, the image processing model may be obtained based on a large number of marked training samples. Specifically, the marked training samples may be input into a preliminary image processing model, and the parameters of the preliminary image processing model may be updated through training.

In some embodiments, the training samples may include remote sensing sample images (also referred to as sample images) and labels each of which corresponds to one of the remote sensing sample images.

In some embodiments, the training samples may be obtained by calling data from a storage device, a database, or related data interfaces, or by using a sensor.

In some embodiments, the labels may be the segmentation results of the top surfaces and the side surfaces of the buildings in the sample images, the pixel heights of the buildings, and the shooting directions of the sample images. In some embodiments, the labels may be obtained through manual marking or automatic marking, which may not be limited in the present disclosure.

In some embodiments, the training may be performed through various techniques based on the training samples. For example, the training may be performed based on a gradient descent technique.

In some embodiments, when the trained model satisfies a preset condition, the training may be completed. The preset condition may include that the loss function converges, the count of iterations reaches a preset number, etc.

In some embodiments, during the training process, the loss function of the model may include a first loss function and a second loss function. The first loss function may be constructed based on the segmentation result of the top surface and the side surface of the building output by the first processing module and the corresponding segmentation result marker. The second loss function may be constructed based on the pixel height of the building and the shooting direction of the remote sensing image output by the second processing module and the corresponding marker.

In some embodiments, the first loss function and the second loss function may be combined to increase the feedback and optimization of the prediction result of the second processing module by the output of the first processing module.

In some embodiments, when the model used to predict the segmentation result of surfaces of the building and the model to predict the pixel height of the building and the shooting direction of the image are independent of each other, the two models (e.g., the two models of the image processing model in the previous example) may also be separately trained based on the same training samples to obtain a trained image processing model.

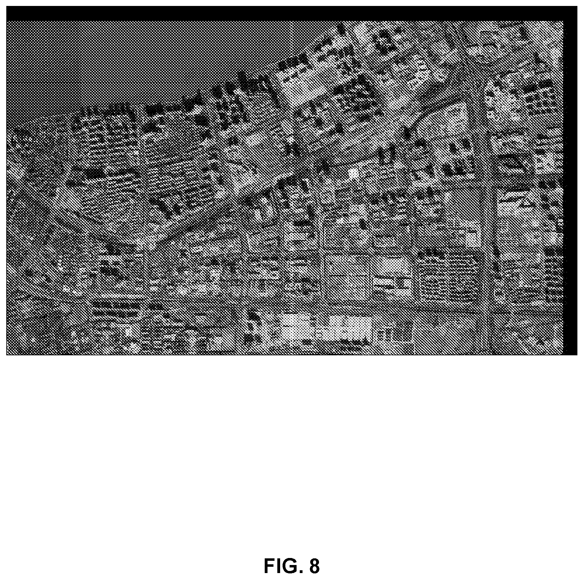

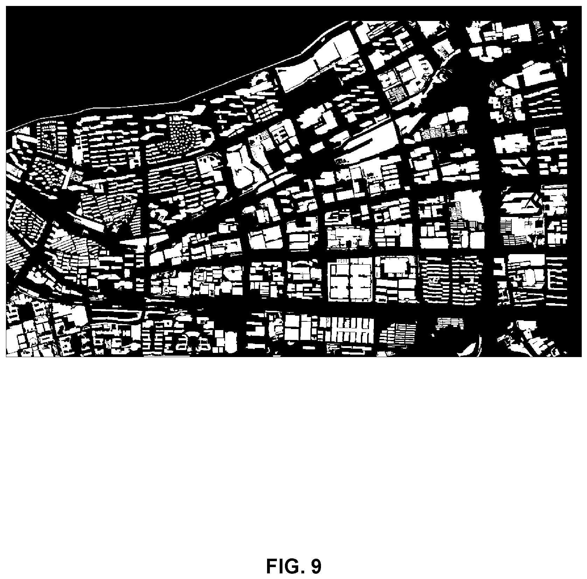

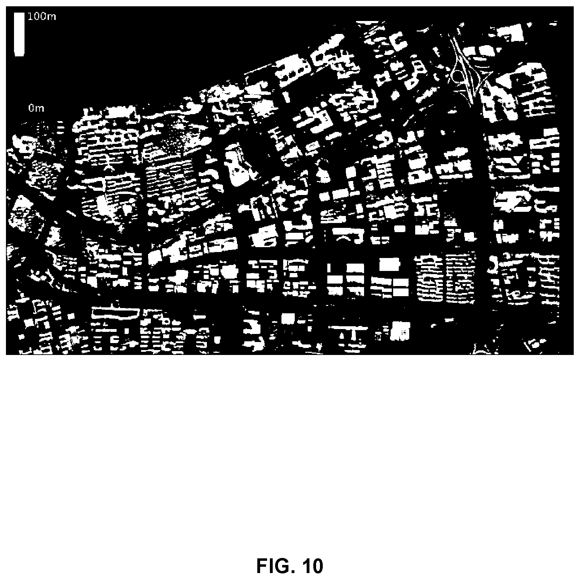

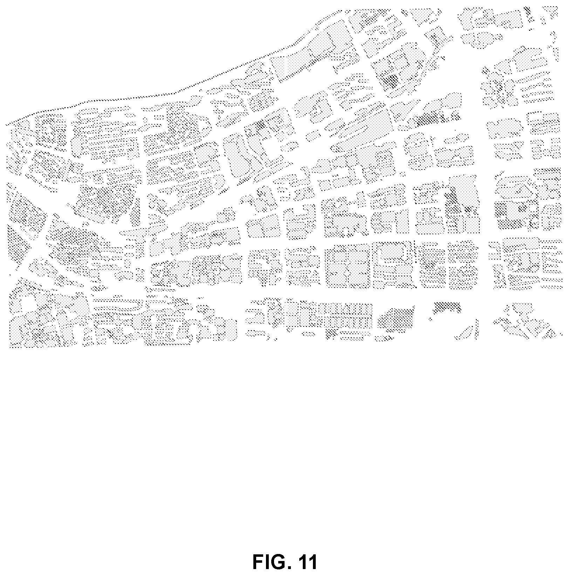

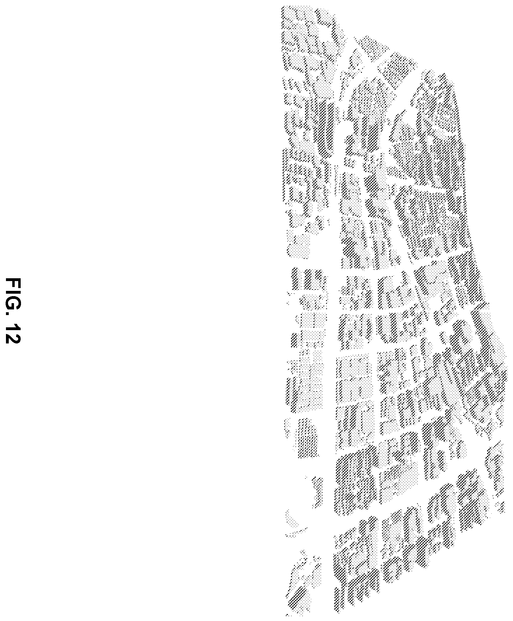

The construction effect of constructing a building block model based on a remote sensing image described in the present disclosure may be shown in FIGs. 8-13. FIG. 8 is a schematic diagram illustrating an exemplary remote sensing image according to some embodiments of the present disclosure. FIG. 9 is a schematic diagram illustrating exemplary segmentation results of buildings according to some embodiments of the present disclosure. FIG. 10 is a schematic diagram illustrating exemplary extraction results of buildings according to some embodiments of the present disclosure. FIG. 11 is a schematic diagram illustrating an exemplary vectorization of buildings according to some embodiments of the present disclosure. FIG. 12 is a schematic diagram illustrating an exemplary building block model according to some embodiments of the present disclosure.

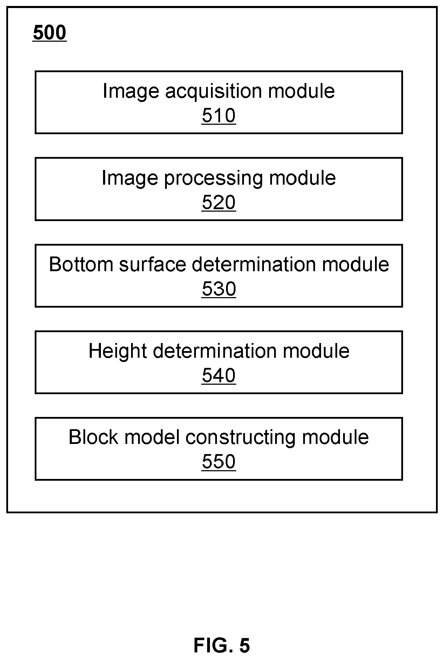

FIG. 5 is a schematic diagram illustrating an exemplary system for constructing a building block model according to some embodiments of the present disclosure. As shown in FIG. 5, the system 500 may include an image acquisition module 510, an image processing module 520, a bottom surface determination module 530, a height determination module 540, and a block model constructing module 550.

The image acquisition module 510 may be configured to obtain a remote sensing image.

The image processing module 520 may be configured to obtain a processing result by processing the remote sensing image using an image processing model. The processing result may include a segmentation result of a top surface of a building in the remote sensing image and feature information of pixels representing the building in the remote sensing image.

The bottom surface determination module 530 may be configured to determine a bottom surface of the building in the remote sensing image based on the processing result.

The height determination module 540 may be configured to determine a height of the building in the remote sensing image based on the feature information of the pixels representing the building.

The block model constructing module 550 may be configured to construct the building block model based on the bottom surface of the building and the height of the building.

It should be noted that the above description about system 500 is merely provided for the purposes of illustration, and not intended to limit the scope of the present disclosure. For persons having ordinary skills in the art, multiple variations and modifications to system 500 may be made under the teachings of the present disclosure. In some embodiments, the image acquisition module 510, the image processing module 520, the bottom surface determination module 530, the height determination module 540, and the block model constructing module 550 may be independent modules in a system. In some embodiments, two or more modules mentioned above may be combined as a module configured to implement the functions thereof. For example, the bottom surface determination module 530 and the height determination module 540 may be two modules, and may also be combined as a module having the functions of determining the bottom surface of the building in the remote sensing image and determining the height of the building in the remote sensing image. As another example, each module may share a single storage module. Each module may also have its own storage module. However, those variations and modifications do not depart from the scope of the present disclosure.

Having thus described the basic concepts, it may be rather apparent to those skilled in the art after reading this detailed disclosure that the foregoing detailed disclosure is intended to be presented by way of example only and is not limiting. Various alterations, improvements, and modifications may occur and are intended to those skilled in the art, though not expressly stated herein. These alterations, improvements, and modifications are intended to be suggested by this disclosure and are within the scope of the exemplary embodiments of this disclosure as set out in the appended claims.

Moreover, certain terminology has been used to describe embodiments of the present disclosure. For example, the terms "one embodiment," "an embodiment," and/or "some embodiments" mean that a particular feature, structure, or characteristic described in connection with the embodiment is included in at least one embodiment of the present disclosure. Therefore, it is emphasized and should be appreciated that two or more references to "an embodiment" or "one embodiment" or "an alternative embodiment" in various portions of this specification are not necessarily all referring to the same embodiment. Furthermore, the particular features, structures, or characteristics may be combined as suitable in one or more embodiments of the present disclosure.

Further, it will be appreciated by one skilled in the art, aspects of the present disclosure may be illustrated and described herein in any of a number of patentable classes or context including any new and useful process, machine, manufacture, or composition of matter, or any new and useful improvement thereof. Accordingly, aspects of the present disclosure may be implemented entirely hardware, entirely software (including firmware, resident software, micro-code, etc.) or combining software and hardware implementation that may all generally be referred to herein as a "unit," "module," or "system." Furthermore, aspects of the present disclosure may take the form of a computer program product embodied in one or more computer-readable media having computer-readable program code embodied thereon.

A non-transitory computer-readable signal medium may include a propagated data signal with computer readable program code embodied therein, for example, in baseband or as part of a carrier wave. Such a propagated signal may take any of a variety of forms, including electromagnetic, optical, or the like, or any suitable combination thereof. A computer-readable signal medium may be any computer-readable medium that is not a computer-readable storage medium and that may communicate, propagate, or transport a program for use by or in connection with an instruction execution system, apparatus, or device. Program code embodied on a computer-readable signal medium may be transmitted using any appropriate medium, including wireless, wireline, optical fiber cable, RF, or the like, or any suitable combination of the foregoing.

Furthermore, the recited order of processing elements or sequences, or the use of numbers, letters, or other designations, therefore, is not intended to limit the claimed processes and methods to any order except as may be specified in the claims. Although the above disclosure discusses through various examples what is currently considered to be a variety of useful embodiments of the disclosure, it is to be understood that such detail is solely for that purpose and that the appended claims are not limited to the disclosed embodiments, but, on the contrary, are intended to cover modifications and equivalent arrangements that are within the scope of the disclosed embodiments, as set out in the appended claims. For example, although the implementation of various components described above may be embodied in a hardware device, it may also be implemented as a software-only solution, e.g., an installation on an existing server or mobile device.

Similarly, it should be appreciated that in the foregoing description of embodiments of the present disclosure, various features are sometimes grouped together in a single embodiment, figure, or description thereof to streamline the disclosure aiding in the understanding of one or more of the various inventive embodiments. This method of disclosure, however, is not to be interpreted as reflecting an intention that the claimed object matter requires more features than are expressly recited in each claim. Rather, inventive embodiments lie in less than all features of a single foregoing disclosed embodiment.

In some embodiments, the numbers expressing quantities, properties, and so forth, used to describe and claim certain embodiments of the application are to be understood as being modified in some instances by the term "about," "approximate," or "substantially." For example, "about," "approximate" or "substantially" may indicate ±20% variation of the value it describes, unless otherwise stated. Accordingly, in some embodiments, the numerical parameters set forth in the written description and attached claims are approximations that may vary depending upon the desired properties sought to be obtained by a particular embodiment. In some embodiments, the numerical parameters should be construed in light of the number of reported significant digits and by applying ordinary rounding techniques. Notwithstanding that the numerical ranges and parameters setting forth the broad scope of some embodiments of the application are approximations, the numerical values set forth in the specific examples are reported as precisely as practicable.

In closing, it is to be understood that the embodiments of the application disclosed herein are illustrative of the principles of the embodiments of the application. Other modifications that may be employed may be within the scope of the application, as set out in the appended claims. Thus, by way of example, but not of limitation, alternative configurations of the embodiments of the application may be utilized in accordance with the teachings herein. Accordingly, embodiments of the present application are not limited to that precisely as shown and described.

## Claims

1. A method for constructing a building block model, comprising:
obtaining a remote sensing image;
obtaining a processing result by processing the remote sensing image using an image processing model, wherein the processing result includes a segmentation result of a top surface of a building in the remote sensing image and feature information of pixels representing the building in the remote sensing image, the feature information of the pixels representing the building including a pixel height of the building in the remote sensing image and a shooting direction of the remote sensing image;
determining, based on the processing result, a bottom surface of the building in the remote sensing image by:
determining, based on the pixel height of the building in the remote sensing image and the shooting direction of the remote sensing image, a height flow vector, wherein the height flow vector includes a first unit component, a second unit component, and the pixel height of the building; and
determining, based on the height flow vector, the bottom surface of the building in the remote sensing image;
determining, based on the feature information of the pixels representing the building, a height of the building in the remote sensing image; and
constructing, based on the bottom surface of the building and the height of the building, the building block model..

2. The method of claim 1, wherein the image processing model includes a deep learning network model, and the image processing model comprises:
a feature extraction module configured to obtain feature data by processing the remote sensing image;
a first processing module configured to determine the segmentation result of the top surface based on the feature data; and
a second processing module configured to determine the feature information of the pixels representing the building in the remote sensing image.

3. The method of claim 2, wherein
the first processing module is further configured to determine a segmentation result of a side surface of the building in the remote sensing image based on the feature data;
the second processing module is further configured to determine the pixel height of the building in the remote sensing image and the shooting direction of the remote sensing image based on the feature data and the segmentation result of the top surface and the side surface of the building.

4. The method of claim 2, wherein the feature extraction module includes a plurality of branches,
the plurality of branches includes at least a first branch and a second branch,
a dimension of the first branch is smaller than that of the second branch, and
a spatial resolution of the first branch is greater than that of the second branch.

5. The method of claim 1, wherein the determining, based on the height flow vector, the bottom surface of the building in the remote sensing image comprises:
determining the bottom surface of the building by mapping the top surface of the building to a bottom of the building based on the height flow vector.

6. The method of any one of claims 1-5, wherein the constructing, based on the bottom surface of the building and the height of the building, the building block model comprises:
determining a vectorized representation of a contour of the bottom surface of the building by vectorizing the bottom surface of the building; and
constructing, based on the height of the building and the vectorized representation of the contour of the bottom surface of the building, the building block model of the building.

7. The method of any one of claims 1-6, wherein the processing result further includes the segmentation result of the side surface of the building in the remote sensing image.

8. A system for constructing a building block model, comprising:
an image acquisition module configured to obtain a remote sensing image;
an image processing module configured to obtain a processing result by processing the remote sensing image using an image processing model, wherein the processing result includes a segmentation result of a top surface of a building in the remote sensing image and feature information of pixels representing the building in the remote sensing image, the feature information of the pixels representing the building including a pixel height of the building in the remote sensing image and a shooting direction of the remote sensing image;
a bottom surface determination module configured to determine, based on the processing result, a bottom surface of the building in the remote sensing image by:
determining, based on the pixel height of the building in the remote sensing image and the shooting direction of the remote sensing image, a height flow vector, wherein, the height flow vector includes a first unit component, a second unit component, and the pixel height of the building; and
determining, based on the height flow vector, the bottom surface of the building in the remote sensing image;
a height determination module configured to determine, based on the feature information of the pixels representing the building, a height of the building in the remote sensing image; and
a block model constructing module configured to construct, based on the bottom surface of the building and the height of the building, the building block model.

9. The system of claim 8, wherein the image processing model includes a deep learning network model, and the image processing model comprises:
a feature extraction module configured to obtain feature data by processing the remote sensing image;
a first processing module configured to determine the segmentation result of the top surface based on the feature data; and
a second processing module configured to determine feature information of the pixels representing the building in the remote sensing image.

10. The system of claim 9, wherein
the first processing module is further configured to determine a segmentation result of a side surface of the building in the remote sensing image based on the feature data;
the second processing module is further configured to determine the pixel height of the building in the remote sensing image and the shooting direction of the remote sensing image based on the feature data and the segmentation result of the top surface and the side surface of the building.

11. The system of claim 10, wherein the feature extraction module includes a plurality of branches,
the plurality of branches includes at least a first branch and a second branch,
a dimension of the first branch is smaller than that of the second branch, and
a spatial resolution of the first branch is greater than that of the second branch.

12. The system of any one of claims 8-11, wherein the block model constructing module further is configured to:
determine a vectorized representation of a contour of the bottom surface of the building by vectorizing the bottom surface of the building; and
construct, based on the height of the building and the vectorized representation of the contour of the bottom surface of the building, the building block model of the building.

13. A non-transitory computer readable medium, comprising at least one set of instructions, wherein when executed by a computer, the at least one set of instructions directs the computer to perform operations including:
obtaining a remote sensing image;
obtaining a processing result by processing the remote sensing image using an image processing model, wherein the processing result includes a segmentation result of a top surface of a building in the remote sensing image and feature information of pixels representing the building in the remote sensing image, the feature information of the pixels representing the building including a pixel height of the building in the remote sensing image and a shooting direction of the remote sensing image;
determining, based on the processing result, a bottom surface of the building in the remote sensing image by:
determining, based on the pixel height of the building in the remote sensing image and the shooting direction of the remote sensing image, a height flow vector, wherein, the height flow vector includes a first unit component, a second unit component, and the pixel height of the building; and
determining, based on the height flow vector, the bottom surface of the building in the remote sensing image;
determining, based on the feature information of the pixels representing the building, a height of the building in the remote sensing image; and
constructing, based on the bottom surface of the building and the height of the building, the building block model.

## Patentansprüche

1. Verfahren zum Konstruieren eines Bausteinmodells, umfassend:
Erhalten eines Fernerkundungsbildes;
Erhalten eines Verarbeitungsergebnisses durch Verarbeiten des Fernerkundungsbildes unter Verwendung eines Bildverarbeitungsmodells, wobei das Verarbeitungsergebnis ein Segmentierungsergebnis einer Deckfläche eines Bauwerks in dem Fernerkundungsbild und Merkmalsinformationen von Pixeln, die das Bauwerk in dem Fernerkundungsbild darstellen, beinhaltet, wobei die Merkmalsinformationen der Pixel, die das Bauwerk darstellen, eine Pixelhöhe des Bauwerks in dem Fernerkundungsbild und eine Aufnahmerichtung des Fernerkundungsbildes beinhalten;
Bestimmen, auf Basis des Verarbeitungsergebnisses, einer Grundfläche des Bauwerks in dem Fernerkundungsbild durch:
Bestimmen, auf Basis der Pixelhöhe des Bauwerks in dem Fernerkundungsbild und der Aufnahmerichtung des Fernerkundungsbildes, eines Höhenströmungsvektors, wobei der Höhenströmungsvektor eine erste Einheitskomponente, eine zweite Einheitskomponente und die Pixelhöhe des Bauwerks beinhaltet; und
Bestimmen, auf Basis des Höhenströmungsvektors, der Grundfläche des Bauwerks in dem Fernerkundungsbild;
Bestimmen, auf Basis der Merkmalsinformationen der Pixel, die das Bauwerk darstellen, einer Höhe des Bauwerks in dem Fernerkundungsbild; und
Konstruieren, auf Basis der Grundfläche des Bauwerks und der Höhe des Bauwerks, des Bausteinmodells.

2. Verfahren nach Anspruch 1, wobei das Bildverarbeitungsmodell ein Deep-Learning-Netzwerkmodell beinhaltet, und das Bildverarbeitungsmodell umfasst:
ein Merkmalsextraktionsmodul, das so konfiguriert ist, dass es Merkmalsdaten durch Verarbeiten des Fernerkundungsbildes erhält;
ein erstes Verarbeitungsmodul, das so konfiguriert ist, dass es das Segmentierungsergebnis der Deckfläche auf Basis der Merkmalsdaten bestimmt; und
ein zweites Verarbeitungsmodul, das so konfiguriert ist, dass es die Merkmalsinformationen der Pixel, die das Bauwerk in dem Fernerkundungsbild darstellen, bestimmt.

3. Verfahren nach Anspruch 2, wobei
das erste Verarbeitungsmodul weiter so konfiguriert ist, dass es ein Segmentierungsergebnis einer Seitenfläche des Bauwerks in dem Fernerkundungsbild auf Basis der Merkmalsdaten bestimmt;
das zweite Verarbeitungsmodul weiter so konfiguriert ist, dass es die Pixelhöhe des Bauwerks in dem Fernerkundungsbild und die Aufnahmerichtung des Fernerkundungsbildes auf Basis der Merkmalsdaten und des Segmentierungsergebnisses der Deckfläche und der Seitenfläche des Bauwerks bestimmt.

4. Verfahren nach Anspruch 2, wobei das Merkmalsextraktionsmodul eine Vielzahl von Zweigen beinhaltet,
die Vielzahl von Zweigen mindestens einen ersten Zweig und einen zweiten Zweig beinhaltet,
eine Abmessung des ersten Zweiges kleiner ist als die des zweiten Zweiges, und
eine räumliche Auflösung des ersten Zweiges größer ist als die des zweiten Zweiges.

5. Verfahren nach Anspruch 1, wobei das Bestimmen, auf Basis des Höhenströmungsvektors, der Grundfläche des Bauwerks in dem Fernerkundungsbild umfasst:
Bestimmen der Grundfläche des Bauwerks durch Abbilden der Deckfläche des Bauwerks auf einen Grund des Bauwerks auf Basis des Höhenströmungsvektors.

6. Verfahren nach einem der Ansprüche 1-5, wobei das Konstruieren des Bausteinmodells auf Basis der Grundfläche des Bauwerks und der Höhe des Bauwerks umfasst:
Bestimmen einer vektorisierten Darstellung eines Umrisses der Grundfläche des Bauwerks durch Vektorisieren der Grundfläche des Bauwerks; und
Konstruieren, auf Basis der Höhe des Bauwerks und der vektorisierten Darstellung des Umrisses der Grundfläche des Bauwerks, des Bausteinmodells des Bauwerks.

7. Verfahren nach einem der Ansprüche 1-6, wobei das Verarbeitungsergebnis weiter das Segmentierungsergebnis der Seitenfläche des Bauwerks in dem Fernerkundungsbild beinhaltet.

8. System zum Konstruieren eines Bausteinmodells, umfassend:
ein Bilderfassungsmodul, das so konfiguriert ist, dass es ein Fernerkundungsbild erhält;
ein Bildverarbeitungsmodul, das so konfiguriert ist, dass es durch Verarbeiten des Fernerkundungsbildes unter Verwendung eines Bildverarbeitungsmodells ein Verarbeitungsergebnis erhält, wobei das Verarbeitungsergebnis ein Segmentierungsergebnis einer Deckfläche eines Bauwerks in dem Fernerkundungsbild und Merkmalsinformationen von Pixeln, die das Bauwerk in dem Fernerkundungsbild darstellen, beinhaltet, wobei die Merkmalsinformationen der Pixel, die das Bauwerk darstellen, eine Pixelhöhe des Bauwerks in dem Fernerkundungsbild und eine Aufnahmerichtung des Fernerkundungsbildes beinhalten;
ein Grundflächenbestimmungsmodul, das so konfiguriert ist, dass es auf Basis des Verarbeitungsergebnisses eine Grundfläche des Bauwerks in dem Fernerkundungsbild bestimmt durch:
Bestimmen, auf Basis der Pixelhöhe des Bauwerks in dem Fernerkundungsbild und der Aufnahmerichtung des Fernerkundungsbildes, eines Höhenströmungsvektors, wobei der Höhenströmungsvektor eine erste Einheitskomponente, eine zweite Einheitskomponente und die Pixelhöhe des Bauwerks beinhaltet; und
Bestimmen, auf Basis des Höhenströmungsvektors, der Grundfläche des Bauwerks in dem Fernerkundungsbild;
ein Höhenbestimmungsmodul, das so konfiguriert ist, dass es auf Basis der Merkmalsinformationen der Pixel, die das Bauwerk darstellen, eine Höhe des Bauwerks in dem Fernerkundungsbild bestimmt; und
ein Bausteinmodell-Konstruktionsmodul, das so konfiguriert ist, dass es auf Basis der Grundfläche des Bauwerks und der Höhe des Bauwerks das Bausteinmodell konstruiert.

9. System nach Anspruch 8, wobei das Bildverarbeitungsmodell ein Deep-Learning-Netzwerkmodell beinhaltet, und das Bildverarbeitungsmodell umfasst:
ein Merkmalsextraktionsmodul, das so konfiguriert ist, dass es Merkmalsdaten durch Verarbeiten des Fernerkundungsbildes erhält;
ein erstes Verarbeitungsmodul, das so konfiguriert ist, dass es das Segmentierungsergebnis der Deckfläche auf Basis der Merkmalsdaten bestimmt; und
ein zweites Verarbeitungsmodul, das so konfiguriert ist, dass es Merkmalsinformationen der Pixel, die das Bauwerk in dem Fernerkundungsbild darstellen, bestimmt.

10. System nach Anspruch 9, wobei
das erste Verarbeitungsmodul weiter so konfiguriert ist, dass es ein Segmentierungsergebnis einer Seitenfläche des Bauwerks in dem Fernerkundungsbild auf Basis der Merkmalsdaten bestimmt;
das zweite Verarbeitungsmodul weiter so konfiguriert ist, dass es die Pixelhöhe des Bauwerks in dem Fernerkundungsbild und die Aufnahmerichtung des Fernerkundungsbildes auf Basis der Merkmalsdaten und des Segmentierungsergebnisses der Deckfläche und der Seitenfläche des Bauwerks bestimmt.

11. System nach Anspruch 10, wobei das Merkmalsextraktionsmodul eine Vielzahl von Zweigen beinhaltet,
die Vielzahl von Zweigen mindestens einen ersten Zweig und einen zweiten Zweig beinhaltet,
eine Abmessung des ersten Zweiges kleiner ist als die des zweiten Zweiges, und
eine räumliche Auflösung des ersten Zweiges größer ist als die des zweiten Zweiges.

12. System nach einem der Ansprüche 8-11, wobei das Bausteinmodell-Konstruktionsmodul weiter so konfiguriert ist, dass es:
eine vektorisierte Darstellung eines Umrisses der Grundfläche des Bauwerks durch Vektorisieren der Grundfläche des Bauwerks bestimmt; und
auf Basis der Höhe des Bauwerks und der vektorisierten Darstellung des Umrisses der Grundfläche des Bauwerks das Bausteinmodell des Bauwerks konstruiert.

13. Nichtflüchtiges computerlesbares Medium, das mindestens einen Satz von Anweisungen umfasst, wobei der mindestens eine Satz von Anweisungen, wenn er von einem Computer ausgeführt wird, den Computer anleitet, Operationen durchzuführen, die beinhalten:
Erhalten eines Fernerkundungsbildes;
Erhalten eines Verarbeitungsergebnisses durch Verarbeiten des Fernerkundungsbildes unter Verwendung eines Bildverarbeitungsmodells, wobei das Verarbeitungsergebnis ein Segmentierungsergebnis einer Deckfläche eines Bauwerks in dem Fernerkundungsbild und Merkmalsinformationen von Pixeln, die das Bauwerk in dem Fernerkundungsbild darstellen, beinhaltet, wobei die Merkmalsinformationen der Pixel, die das Bauwerk darstellen, eine Pixelhöhe des Bauwerks in dem Fernerkundungsbild und eine Aufnahmerichtung des Fernerkundungsbildes beinhalten;
Bestimmen, auf Basis des Verarbeitungsergebnisses, einer Grundfläche des Bauwerks in dem Fernerkundungsbild durch:
Bestimmen, auf Basis der Pixelhöhe des Bauwerks in dem Fernerkundungsbild und der Aufnahmerichtung des Fernerkundungsbildes, eines Höhenströmungsvektors, wobei der Höhenströmungsvektor eine erste Einheitskomponente, eine zweite Einheitskomponente und die Pixelhöhe des Bauwerks beinhaltet; und
Bestimmen, auf Basis des Höhenströmungsvektors, der Grundfläche des Bauwerks in dem Fernerkundungsbild;
Bestimmen, auf Basis der Merkmalsinformationen der Pixel, die das Bauwerk darstellen, einer Höhe des Bauwerks in dem Fernerkundungsbild; und
Konstruieren, auf Basis der Grundfläche des Bauwerks und der Höhe des Bauwerks, des Bausteinmodells.

## Revendications

1. Procédé de construction d'un modèle de bloc de bâtiment, comprenant :
l'obtention d'une image de télédétection ;
l'obtention d'un résultat de traitement en traitant l'image de télédétection à l'aide d'un modèle de traitement d'image, dans lequel le résultat de traitement inclut un résultat de segmentation d'une surface supérieure d'un bâtiment dans l'image de télédétection et des informations de caractéristiques de pixels représentant le bâtiment dans l'image de télédétection, les informations de caractéristiques des pixels représentant le bâtiment incluant une hauteur en pixels du bâtiment dans l'image de télédétection et une direction de prise de vue de l'image de télédétection ;
la détermination, sur la base du résultat de traitement, d'une surface inférieure du bâtiment dans l'image de télédétection en :
déterminant, sur la base de la hauteur en pixels du bâtiment dans l'image de télédétection et de la direction de prise de vue de l'image de télédétection, un vecteur de flux de hauteur, dans lequel le vecteur de flux de hauteur inclut une première composante unitaire, une seconde composante unitaire et la hauteur en pixels du bâtiment ; et
déterminant, sur la base du vecteur de flux de hauteur, la surface inférieure du bâtiment dans l'image de télédétection ;
déterminant, sur la base des informations de caractéristiques des pixels représentant le bâtiment, une hauteur du bâtiment dans l'image de télédétection ; et
construisant, sur la base de la surface inférieure du bâtiment et de la hauteur du bâtiment, le modèle de bloc de bâtiment.

2. Procédé selon la revendication 1, dans lequel le modèle de traitement d'image inclut un modèle de réseau d'apprentissage profond, et le modèle de traitement d'image comprend :
un module d'extraction de caractéristiques configuré pour obtenir des données de caractéristiques en traitant l'image de télédétection ;
un premier module de traitement configuré pour déterminer le résultat de segmentation de la surface supérieure sur la base des données de caractéristiques ; et
un second module de traitement configuré pour déterminer les informations de caractéristiques des pixels représentant le bâtiment dans l'image de télédétection.

3. Procédé selon la revendication 2, dans lequel
le premier module de traitement est en outre configuré pour déterminer un résultat de segmentation d'une surface latérale du bâtiment dans l'image de télédétection sur la base des données de caractéristiques ;
le second module de traitement est en outre configuré pour déterminer la hauteur en pixels du bâtiment dans l'image de télédétection et la direction de prise de vue de l'image de télédétection sur la base des données de caractéristiques et du résultat de segmentation de la surface supérieure et de la surface latérale du bâtiment.

4. Procédé selon la revendication 2, dans lequel le module d'extraction de caractéristiques inclut une pluralité de branches,
la pluralité de branches inclut au moins une première branche et une seconde branche,
une dimension de la première branche est inférieure à celle de la seconde branche, et
une résolution spatiale de la première branche est supérieure à celle de la seconde branche.

5. Procédé selon la revendication 1, dans lequel la détermination, sur la base du vecteur de flux de hauteur, de la surface inférieure du bâtiment dans l'image de télédétection comprend :
la détermination de la surface inférieure du bâtiment en mettant en correspondance la surface supérieure du bâtiment avec une base du bâtiment sur la base du vecteur de flux de hauteur.

6. Procédé selon l'une quelconque des revendications 1-5, dans lequel la construction, sur la base de la surface inférieure du bâtiment et de la hauteur du bâtiment, du modèle de bloc de bâtiment comprend :
la détermination d'une représentation vectorisée d'un contour de la surface inférieure du bâtiment en vectorisant la surface inférieure du bâtiment ; et
la construction, sur la base de la hauteur du bâtiment et de la représentation vectorisée du contour de la surface inférieure du bâtiment, du modèle de bloc de bâtiment du bâtiment.

7. Procédé selon l'une quelconque des revendications 1-6, dans lequel le résultat de traitement inclut en outre le résultat de segmentation de la surface latérale du bâtiment dans l'image de télédétection.

8. Système de construction d'un modèle de bloc de bâtiment, comprenant :
un module d'acquisition d'image configuré pour obtenir une image de télédétection ;
**un** module de traitement d'image configuré pour obtenir **un** résultat de traitement en traitant l'image de télédétection à l'aide d'un modèle de traitement d'image, dans lequel le résultat de traitement inclut un résultat de segmentation d'une surface supérieure d'un bâtiment dans l'image de télédétection et des informations de caractéristiques de pixels représentant le bâtiment dans l'image de télédétection, les informations de caractéristiques des pixels représentant le bâtiment incluant une hauteur en pixels du bâtiment dans l'image de télédétection et une direction de prise de vue de l'image de télédétection ;
un module de détermination de la surface inférieure configuré pour déterminer, sur la base du résultat de traitement, une surface inférieure du bâtiment dans l'image de télédétection en :
déterminant, sur la base de la hauteur en pixels du bâtiment dans l'image de télédétection et de la direction de prise de vue de l'image de télédétection, un vecteur de flux de hauteur, dans lequel le vecteur de flux de hauteur inclut une première composante unitaire, une seconde composante unitaire et la hauteur en pixels du bâtiment ; et
déterminant, sur la base du vecteur de flux de hauteur, la surface inférieure du bâtiment dans l'image de télédétection ;
un module de détermination de hauteur configuré pour déterminer, sur la base des informations de caractéristiques des pixels représentant le bâtiment, une hauteur du bâtiment dans l'image de télédétection ; et
un module de construction de modèle de bloc configuré pour construire, sur la base de la surface inférieure du bâtiment et de la hauteur du bâtiment, le modèle de bloc de bâtiment.

9. Système selon la revendication 8, dans lequel le modèle de traitement d'image inclut un modèle de réseau d'apprentissage profond, et le modèle de traitement d'image comprend :
un module d'extraction de caractéristiques configuré pour obtenir des données de caractéristiques en traitant l'image de télédétection ;
un premier module de traitement configuré pour déterminer le résultat de segmentation de la surface supérieure sur la base des données de caractéristiques ; et
un second module de traitement configuré pour déterminer des informations de caractéristiques des pixels représentant le bâtiment dans l'image de télédétection.

10. Système selon la revendication 9, dans lequel
le premier module de traitement est en outre configuré pour déterminer un résultat de segmentation d'une surface latérale du bâtiment dans l'image de télédétection sur la base des données de caractéristiques ;
le second module de traitement est en outre configuré pour déterminer la hauteur en pixels du bâtiment dans l'image de télédétection et la direction de prise de vue de l'image de télédétection sur la base des données de caractéristiques et du résultat de segmentation de la surface supérieure et de la surface latérale du bâtiment.

11. Système selon la revendication 10, dans lequel le module d'extraction de caractéristiques inclut une pluralité de branches,
la pluralité de branches inclut au moins une première branche et une seconde branche,
une dimension de la première branche est inférieure à celle de la seconde branche, et
une résolution spatiale de la première branche est supérieure à celle de la seconde branche.

12. Système selon l'une quelconque des revendications 8-11, dans lequel le module de construction de modèle de bloc est en outre configuré pour :
déterminer une représentation vectorisée d'un contour de la surface inférieure du bâtiment en vectorisant la surface inférieure du bâtiment ; et
construire, sur la base de la hauteur du bâtiment et de la représentation vectorisée du contour de la surface inférieure du bâtiment, le modèle de bloc de bâtiment du bâtiment.

13. Support non transitoire lisible par ordinateur, comprenant au moins un ensemble d'instructions, dans lequel, lorsqu'il est exécuté par un ordinateur, le au moins un ensemble d'instructions dirige l'ordinateur pour qu'il réalise des opérations incluant :
l'obtention d'une image de télédétection ;
l'obtention d'un résultat de traitement en traitant l'image de télédétection à l'aide d'un modèle de traitement d'image, dans lequel le résultat de traitement inclut un résultat de segmentation d'une surface supérieure d'un bâtiment dans l'image de télédétection et des informations de caractéristiques de pixels représentant le bâtiment dans l'image de télédétection, les informations de caractéristiques des pixels représentant le bâtiment incluant une hauteur en pixels du bâtiment dans l'image de télédétection et une direction de prise de vue de l'image de télédétection ;
la détermination, sur la base du résultat de traitement, d'une surface inférieure du bâtiment dans l'image de télédétection en :
déterminant, sur la base de la hauteur en pixels du bâtiment dans l'image de télédétection et de la direction de prise de vue de l'image de télédétection, un vecteur de flux de hauteur, dans lequel le vecteur de flux de hauteur inclut une première composante unitaire, une seconde composante unitaire et la hauteur en pixels du bâtiment ; et
déterminant, sur la base du vecteur de flux de hauteur, la surface inférieure du bâtiment dans l'image de télédétection ;
déterminant, sur la base des informations de caractéristiques des pixels représentant le bâtiment, une hauteur du bâtiment dans l'image de télédétection ; et
construisant, sur la base de la surface inférieure du bâtiment et de la hauteur du bâtiment, le modèle de bloc de bâtiment.
